# FASCICULE DE BREVET EUROPEEN

(11) **EP 2 782 435 B1**
(45) Date de publication et mention de la délivrance du brevet: **12.07.2017**
(21) Numéro de dépôt: 14160537.8
(22) Date de dépôt: 18.03.2014
(51) Int. Cl.: H05K 7/20

(54) **Convertisseur de puissance électrique pour un véhicule ferroviaire**
Elektrischer Leistungswandler für ein Schienenfahrzeug
Electric power converter for a rail vehicle

(30) Priorité: 22.03.2013 FR 1352597
(43) Date de publication de la demande: 24.09.2014
(73) Titulaire: ALSTOM Transport Technologies, 93400 Saint-Ouen (FR)
(72) Inventeur: Nicolau, Sébastien, 65100 LOUBAJAC (FR); Chauchat, Bertrand, 65360 SALLES ADOUR (FR)
(74) Mandataire: Lavoix

(56) Documents cités:
- EP-A1- 2 291 067
- FR-A1- 2 979 982
- US-A1- 2012 132 402

## Description

La présente invention concerne un convertisseur de puissance électrique pour un véhicule ferroviaire, du type comportant :
- un premier composant électromagnétique propre à participer à la conversion du courant électrique,
- un organe source de chaleur, distinct du premier composant électromagnétique, et
- un circuit de refroidissement, comprenant :
   ∘ un fluide caloporteur diphasique,
   ∘ une boucle de circulation du fluide caloporteur, comprenant :
      ▪ un premier échangeur thermique, appliqué contre ledit premier composant électromagnétique,
      ▪ un deuxième échangeur thermique propre à évacuer la chaleur du fluide caloporteur hors du circuit de refroidissement, et
      ▪ des moyens de mise en communication fluidique du premier échangeur thermique avec le deuxième échangeur thermique, et
   ∘ des moyens de mise en circulation du fluide caloporteur dans la boucle de refroidissement.

Les véhicules ferroviaires nécessitent, pour l'alimentation électrique des moteurs de traction, de disposer de convertisseurs de puissance électrique embarqués. Du fait des puissances très importantes, les convertisseurs doivent être refroidis pour évacuer la chaleur qu'ils produisent.

Les convertisseurs comprennent notamment des transformateurs dont le refroidissement est généralement assuré par une première boucle de refroidissement dans laquelle circule une huile. L'huile est un isolant électrique. Elle circule en circuit fermé dans la boucle entre une chambre, dans laquelle le transformateur baigne dans l'huile, et un échangeur à air. Une pompe mécanique assure la mise en mouvement de l'huile.

Les convertisseurs comprennent également des onduleurs, dont le refroidissement est généralement assuré par une deuxième boucle de refroidissement, indépendante de la première boucle de refroidissement, dans laquelle circule de l'eau glycolée. Cette eau glycolée circule en circuit fermé entre un échangeur thermique en contact avec les organes de commutation de l'onduleur, et un second échangeur à air, une pompe mécanique assurant la mise en mouvement de l'eau glycolée.

Ces boucles de refroidissement sont relativement encombrantes, notamment du fait des pompes, et nécessitent un entretien important, également lié à la présence des pompes, ce qui augmente les coûts d'exploitation et de maintenance du véhicule ferroviaire.

On connaît de FR-A-2 949 642 un convertisseur de puissance électrique pour véhicule ferroviaire dans lequel une pompe capillaire est substituée à la pompe mécanique de la deuxième boucle de refroidissement. Cela permet de réduire l'encombrement du convertisseur de puissance électrique et d'abaisser ses coûts de maintenance, mais ne résout pas le problème lié à l'encombrement et à l'entretien de la première boucle de refroidissement.

L'invention a pour but de proposer un convertisseur de puissance électrique pour un véhicule ferroviaire peu encombrant et nécessitant une maintenance réduite.

A cet effet, l'invention a pour objet un convertisseur de puissance électrique du type précité, dans lequel le circuit de refroidissement est adapté pour refroidir l'organe source de chaleur, et les moyens de mise en circulation comprennent au moins un évaporateur capillaire, traversé par le fluide caloporteur et appliqué contre l'organe source de chaleur, le fluide caloporteur circulant dans la boucle de refroidissement sous l'effet de la pression générée au niveau de l'interface liquide/vapeur dans le ou chaque évaporateur capillaire.

Suivant des modes particuliers de réalisation, le convertisseur de puissance électrique comporte l'une ou plusieurs des caractéristiques suivantes :
- le ou chaque évaporateur capillaire comprend une mèche capillaire propre à assurer une vaporisation complète du fluide caloporteur, reçu à l'état liquide depuis une conduite de transport de fluide de refroidissement, et à renvoyer le fluide caloporteur en totalité à l'état gazeux par une conduite de transport de vapeur,
- la vaporisation complète a lieu au niveau d'un ménisque établi dans la mèche et séparant les phases liquide et vapeur du fluide caloporteur,
- le circuit de refroidissement est dépourvu de pompe mécanique de mise en circulation du fluide caloporteur dans la boucle,
- l'organe source de chaleur est un deuxième composant électromagnétique, propre à participer à la conversion du courant électrique et ayant une émission thermique supérieure à celle du premier composant électromagnétique, par exemple un composant électrique de puissance,
- la boucle comprend le ou chaque évaporateur capillaire, le premier échangeur thermique et le ou chaque évaporateur capillaire étant raccordés fluidiquement en série l'un à l'autre au travers du deuxième échangeur thermique,
- le deuxième échangeur thermique est en aval du premier échangeur thermique et en amont du ou de chaque évaporateur capillaire,
- la boucle comprend une branche d'amenée du fluide caloporteur depuis le premier échangeur de chaleur jusqu'au ou à chaque évaporateur capillaire, et une branche, parallèle à la branche d'amenée, de retour du fluide caloporteur depuis le ou chaque troisième évaporateur capillaire jusqu'au premier échangeur de chaleur,
- le deuxième échangeur thermique est monté sur la branche d'amenée, et la boucle comprend un quatrième échangeur thermique, propre à évacuer la chaleur du fluide caloporteur hors du circuit de refroidissement et monté sur la branche de retour,
- la boucle est une boucle à pompage capillaire,
- le circuit de refroidissement comporte, en amont du ou de chaque évaporateur capillaire, un réservoir de pressurisation du fluide caloporteur à l'état liquide, le réservoir étant placé à un niveau supérieur à celui du ou de chaque évaporateur capillaire,
- le circuit de refroidissement comprend des moyens de contrôle des paramètres de pression et/ou de température du fluide caloporteur en amont du ou de chaque évaporateur capillaire,
- dans lequel le premier échangeur de chaleur comprend une conduite de circulation du fluide caloporteur, et un matériau diélectrique conducteur thermique, interposé entre le premier composant et la conduite de circulation,
- dans lequel le premier composant est un composant magnétique, par exemple un transformateur ou une bobine d'induction, ou un composant capacitif, par exemple un condensateur ou un accumulateur.

L'invention a également pour objet un véhicule ferroviaire comportant une chaîne de traction comprenant un moteur électrique et un convertisseur de puissance électrique tel que défini ci-dessus.

L'invention sera mieux comprise à la lecture de la description qui va suivre, donnée uniquement à titre d'exemple, et faite en se référant aux dessins, sur lesquels :
- la figure 1 est une vue en perspective d'un convertisseur embarqué selon l'invention ; et
- la figure 2 est une vue schématique du circuit de refroidissement du convertisseur de la figure 1.

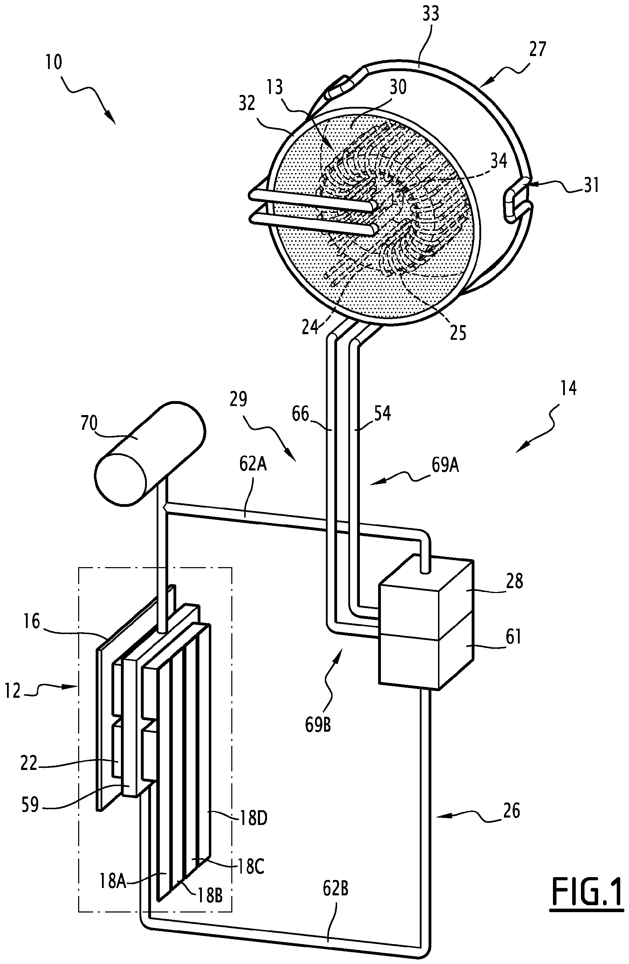

Sur la figure 1 est représenté un convertisseur de puissance électrique 10 pour un véhicule ferroviaire. Ce convertisseur est normalement embarqué dans une locomotive ou dans un véhicule moteur d'une rame de transport de passagers ou de fret. Le convertisseur 10 alimente dans le véhicule un moteur électrique d'une chaîne de traction. Il comporte, comme connu en soi un onduleur 12, par exemple à quatre phases, un premier composant électromagnétique 13 propre à participer à la conversion du courant électrique, par exemple un transformateur 13, et un circuit 14 de refroidissement de l'onduleur 12 et du transformateur 13.

L'onduleur 12 est propre à transformer un courant continu provenant par exemple de la caténaire en un courant triphasé avec une fonction rhéostatique associée.

Comme connu en soi, l'onduleur 12 comporte un bus d'entrée continu 16, quatre barres de conduction de puissance 18A, 18B, 18C, 18D, correspondant chacune à une phase de l'onduleur et à la fonction rhéostatique, et au moins un organe 22 source de chaleur, par exemple quatre organes de commutation à semi-conducteur 22 montés en parallèle entre le bus 16 et chaque barre de puissance 18A, 18B, 18C, 18D.

Les organes 22 forment chacun un transistor bipolaire à grille isolée (connu sous l'acronyme anglais « IGBT » pour « Insulated Gate Bipolar Transistor ».)

Le transformateur 13 comprend, comme connu en soi, un noyau magnétique 24 entouré d'un bobinage 25. Le noyau magnétique 24 est par exemple, comme représenté, torique.

Les organes de commutation 22 ont, lorsque le convertisseur 10 est en fonctionnement, une émission thermique supérieure à celle du transformateur 13.

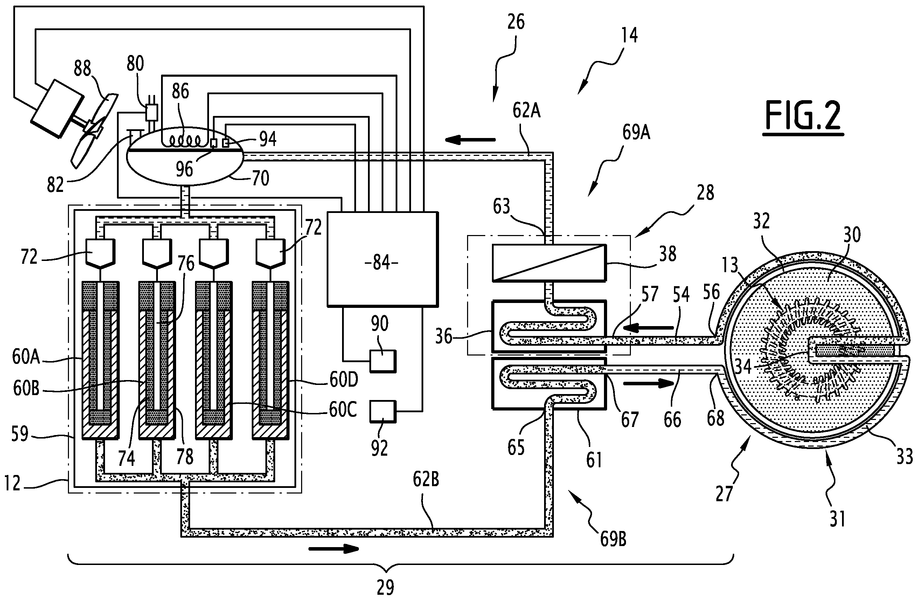

On notera que, pour des raisons de clarté, le bus d'entrée continu 16, les barres de puissance 18 et les organes de commutation 22 ont été omis de la représentation de l'onduleur 12 sur la figure 2.

Le circuit de refroidissement 14, représenté schématiquement sur la figure 2, est un circuit fermé. Il assure la dissipation de la chaleur produite par le transformateur 13 et le maintien de la température du transformateur 13 à une valeur sensiblement constante. Il assure également la dissipation de la chaleur produite par les organes de commutation 22 et le maintien de la température de jonction de ces organes de commutation 22.

A cet effet, le circuit de refroidissement 14 forme une boucle 26 pour la circulation d'un fluide caloporteur, par exemple du méthanol, de refroidissement du transformateur 13 et de l'onduleur 12.

Cette boucle de refroidissement 26 comprend un premier échangeur de chaleur 27, appliqué contre le transformateur 13, et un deuxième échangeur de chaleur 28, propre à évacuer la chaleur du fluide caloporteur hors du circuit de refroidissement 14. Elle comprend également des moyens 29 de mise en communication fluidique des premier et deuxième échangeurs de chaleur 27, 28, propres à guider le fluide de refroidissement entre le premier échangeur de chaleur 27 et le deuxième échangeur de chaleur 28.

Le premier échangeur de chaleur 27 comprend un matériau diélectrique 30 et une conduite 31 de circulation du fluide de refroidissement. Il comprend également un carter 32 de support de la conduite 31.

Le matériau diélectrique 30 est en contact avec le transformateur 13. Il enveloppe intégralement le transformateur 13. Il s'étend autour et à l'intérieur du transformateur 13.

Le matériau diélectrique 30 est un bon conducteur thermique, c'est-à-dire qu'il a conductivité thermique supérieure à 1 W.m⁻¹.K⁻¹, de préférence supérieure à 2 W.m⁻¹.K⁻¹. Le matériau diélectrique 30 est de préférence solide, par exemple une résine dopée ou une matrice carbone. En variante, le matériau diélectrique 30 est une huile.

Le matériau diélectrique 30 est interposé principalement entre le carter 32 et le transformateur 13.

La conduite 31 comprend une portion périphérique 33, qui longe le matériau diélectrique 30, et une portion intérieure 34, qui s'étend dans le matériau diélectrique 30. La portion intérieure 34 s'étend en particulier à l'intérieur du transformateur 13, de façon à éviter la formation d'un point chaud à cet endroit.

Le carter 32 s'étend autour du matériau diélectrique 30. Il est intercalé entre le matériau diélectrique 30 et la portion périphérique 33 de la conduite 31. Il a également une bonne conductivité thermique, typiquement supérieure à 1 W.m⁻¹.K⁻¹.

Le deuxième échangeur de chaleur 28 est un étage de condensation.

Il comporte un condenseur principal 36, visible sur la figure 2, propre à assurer un échange thermique entre la vapeur issue du premier échangeur de chaleur 27 et le milieu ambiant. A cet effet, le condenseur 36 présente des ailettes latérales en contact avec l'atmosphère environnant.

En aval du condenseur principal 36, l'étage de condensation 28 comporte un échangeur de sous-refroidissement 38 propre à condenser la vapeur, qui, accidentellement aurait pu ne pas être totalement condensée dans le condenseur principal 36.

Les moyens de mise en communication fluidique 29 comprennent une conduite 54 de transfert du fluide de refroidissement à l'état gazeux depuis une sortie 56 de la conduite 31 jusqu'à une entrée 57 du deuxième échangeur de chaleur 28.

Les moyens de mise en communication fluidique 29 comprennent également une pluralité de troisièmes échangeurs de chaleur 60A, 60B, 60C, 60D, plaqués chacun contre une surface d'échanges de l'un des organes de commutation 22, et propre à transférer dans le circuit de refroidissement 14 la chaleur produite par ledit organe de commutation 22, un quatrième échangeur de chaleur 61, propre à évacuer la chaleur du fluide caloporteur hors du circuit de refroidissement 14, une conduite 62A de transport du fluide de refroidissement à l'état liquide depuis une sortie 63 du deuxième échangeur de chaleur 28 jusqu'aux troisièmes échangeurs de chaleur 60A, 60B, 60C, 60D, une conduite 62B de transport, ou d'évacuation, du fluide de refroidissement à l'état gazeux hors des échangeurs de chaleur 60A, 60B, 60C, 60D jusqu'à une entrée 65 du quatrième échangeur de chaleur 61, et une conduite 66 de transport du fluide de refroidissement à l'état liquide depuis une sortie 67 du quatrième échangeur de chaleur 61 jusqu'à une entrée 68 de la conduite 31.

Ainsi, le fluide de refroidissement circulant dans la boucle 26 est un fluide diphasique, celui-ci étant sous forme de liquide seulement dans certaines parties de la boucle 26 et sous forme de vapeur seulement dans d'autres parties de la boucle 26.

On notera en outre que les premier, deuxième et quatrième échangeurs de chaleur 27, 28, 61 sont ainsi raccordés fluidiquement en série les uns avec les autres et avec chaque troisième échangeur de chaleur 60A, 60B, 60C, 60D en formant une boucle, le deuxième échangeur de chaleur 28 étant en aval du premier échangeur de chaleur 27 et en amont de chaque troisième échangeur de chaleur 60A, 60B, 60C, 60D, et le quatrième échangeur de chaleur 61 étant en aval de chaque troisième échangeur de chaleur 60A, 60B, 60C, 60D et en amont du premier échangeur de chaleur 27, relativement à un sens de circulation du fluide de refroidissement dans la boucle 26. En particulier, la conduite 54, le deuxième échangeur de chaleur 28 et la conduite 62A forment une branche 69A d'amenée du fluide de refroidissement depuis le premier échangeur de chaleur 27 jusqu'à chaque troisième échangeur de chaleur 60A, 60B, 60C, 60D, et la conduite 62B, le quatrième échangeur de chaleur 61 et la conduite 66 forment une branche 69B, parallèle à la branche 69A, de retour du fluide de refroidissement depuis chaque troisième échangeur de chaleur 60A, 60B, 60C, 60D jusqu'au premier échangeur de chaleur 27. Par « parallèle », on comprend que les branches 69A et 69B ne se croisent pas.

Le quatrième échangeur de chaleur 61 est un condenseur propre à assurer un échange thermique entre la vapeur issue des évaporateurs capillaires et le milieu ambiant. A cet effet, le quatrième échangeur de chaleur 61 présente des ailettes latérales en contact avec l'atmosphère environnant. De préférence, le quatrième échangeur de chaleur 61 est accolé au deuxième échangeur de chaleur 28, en particulier accolé au condenseur 36 du deuxième échangeur de chaleur 28.

Le circuit de refroidissement 14 comprend également des moyens 59 de mise en circulation du fluide de refroidissement dans la boucle de refroidissement 26. Ces moyens de mise en circulation 59, visibles sur les figures 1 et 2, sont dépourvus de toute pompe électromécanique. Ils sont en particulier formés par les troisièmes échangeurs de chaleur 60A, 60B, 60C, 60D.

A cet effet, chaque troisième échangeur de chaleur 60A, 60B, 60C, 60D est un évaporateur capillaire, constituant une pompe capillaire propre à recevoir en entrée le fluide de refroidissement à l'état liquide et à délivrer en sortie ce fluide en phase vapeur uniquement. La boucle de refroidissement 26 constitue ainsi une boucle à pompage capillaire.

Ces évaporateurs capillaires 60A, 60B, 60C, 60D sont montés en parallèle et sont disposés verticalement pour recevoir, dans leurs parties supérieures, le fluide de refroidissement circulant dans la boucle 26 en phase liquide et produire à leurs extrémités inférieures de la vapeur du même fluide.

Depuis leurs extrémités supérieures, les quatre évaporateurs capillaires 60A, 60B, 60C, 60D sont reliés à un même réservoir pressurisateur diphasique 70 de fluide de refroidissement par l'intermédiaire de quatre isolateurs 72 propres à empêcher un retour de vapeur vers le réservoir 70, par exemple en cas de désamorçage d'un évaporateur 60A, 60B, 60C, 60D créé par une trop forte injection de puissance thermique.

Le réservoir 70 est placé à la verticale des évaporateurs capillaires 60A, 60B, 60C, 60D, au-dessus de ces derniers, le liquide de refroidissement étant soutiré du réservoir 70 pour alimenter par pompage par dépression et par gravité les évaporateurs capillaires 60A, 60B, 60C, 60D.

Les sorties inférieures de vapeur des quatre évaporateurs capillaires 60A, 60B, 60C, 60D se rejoignent en la conduite d'évacuation 62B, qui alimente l'entrée 65 du quatrième échangeur de chaleur 61 en vapeur issue des évaporateurs capillaires 60A, 60B, 60C, 60D.

La sortie 63 du deuxième échangeur de chaleur 28 est reliée fluidiquement par la conduite 62A au réservoir 70, qui y transfère le fluide de refroidissement à l'état liquide issu du deuxième échangeur de chaleur 28.

Chaque évaporateur capillaire 60A, 60B, 60C, 60D est en particulier formé d'un tube fermé, à l'exception de son entrée et de sa sortie. Il présente une forme parallélépipédique, sur une face duquel sont appliqués les organes de commutation 22.

Une mèche capillaire 74 est logée à l'intérieur du tube et définit dans l'évaporateur une chambre interne 76 de réception du fluide de refroidissement à l'état liquide et une chambre périphérique 78 de sortie du fluide de refroidissement à l'état vapeur. Ces deux chambres 76 et 78 sont parfaitement séparées par la mèche capillaire 74, de sorte que seul du liquide existe dans la chambre 76 et seule de la vapeur est présente dans la chambre 78, les deux phases liquide et vapeur étant parfaitement séparées. La circulation du fluide de refroidissement s'effectue donc de manière radiale de la chambre interne 76 vers la chambre externe 78.

Chaque évaporateur capillaire 60A, 60B, 60C, 60D assure une transformation du fluide de refroidissement à l'état liquide en vapeur sous l'action de la chaleur produite par les organes de commutation 22, qui constituent ainsi des sources de chaleur accolées aux évaporateurs capillaires 60A, 60B, 60C, 60D. Ces évaporateurs capillaires 60A, 60B, 60C, 60D assurent le rôle de pompe dans le circuit fermé 14.

La mise en circulation du fluide résulte de l'augmentation de la pression de vapeur dans les évaporateurs capillaires 60A, 60B, 60C, 60D. Cette augmentation de la pression de vapeur est générée au niveau de ménisques où a lieu la vaporisation totale du liquide. Ces ménisques sont formés dans la mèche capillaire 74 où le liquide se réchauffe très rapidement et se vaporise totalement.

La vaporisation au niveau des ménisques s'effectue à température quasi-constante. L'augmentation de la pression est proportionnelle à la tension superficielle du fluide et inversement proportionnelle au rayon équivalent des ménisques.

Le débit de fluide dans chaque évaporateur capillaire 60A, 60B, 60C, 60D est ainsi constamment auto-ajusté afin d'avoir uniquement de la vapeur pure à la sortie de chaque évaporateur 60A, 60B, 60C, 60D.

On comprend que le fluide de refroidissement ainsi mis en mouvement, au niveau des évaporateurs capillaires 60A, 60B, 60C, 60D formant pompe, voit sa phase vapeur amenée à circuler jusqu'au quatrième échangeur de chaleur 61, où la chaleur est dissipée dans l'atmosphère, ce qui conduit à une liquéfaction du fluide de refroidissement, pendant que la phase liquide du fluide de refroidissement sortant du deuxième échangeur de chaleur 28 se voit aspirée par dépression vers le réservoir 70 dans lequel les évaporateurs capillaires 60A, 60B, 60C, 60D aspirent le liquide de refroidissement.

On comprend également que la dépression ainsi causée dans le deuxième échangeur de chaleur 28 entraîne l'aspiration du fluide de refroidissement sortant sous forme vapeur du premier échangeur de chaleur 27 vers le deuxième échangeur de chaleur 28, ce qui entraîne également, par répercussion, l'aspiration du fluide refroidissement sortant sous phase liquide du quatrième échangeur de chaleur 61 vers le premier échangeur de chaleur 27.

On comprend enfin que l'alignement vertical du réservoir 70 au-dessus des évaporateurs capillaires 60A, 60B, 60C, 60D permet, du fait de l'action de la gravité, l'évacuation d'éventuelles bulles de vapeur formées au sein de la mèche capillaire 74, et donc d'assurer un fonctionnement optimal des évaporateurs capillaires 60A, 60B, 60C, 60D.

Le fluide de refroidissement contenu dans le réservoir 70 présente une phase liquide surmontée par un ciel gazeux.

Le réservoir 70 est équipé d'une soupape de dégazage commandable 80 placée au sommet du réservoir 70 et d'un orifice de remplissage 82 normalement fermé.

Pour assurer une régulation de la température de jonction des organes de commutation 22, le réservoir 70 est équipé de moyens de chauffage et de refroidissement reliés à une unité centrale de pilotage 84.

Ainsi, une résistance chauffante 86 est placée dans le ciel gazeux du réservoir 70 pour assurer un échauffement. De même, un ventilateur 88 est placé en regard du réservoir 70 pour assurer le refroidissement de celui-ci.

La résistance 86 et le ventilateur 88 sont pilotés par l'unité de pilotage 84, laquelle est reliée à un capteur 90 de mesure de la puissance électrique consommée par le moteur, celle-ci étant par exemple définie à partir du manipulateur d'accélération du véhicule ferroviaire à la disposition du conducteur.

De même, l'unité de pilotage 84 est reliée à un capteur 92 de mesure de la température de jonction des organes de commutation 22.

Enfin, un capteur de pression 94 et un capteur de température 96, reliés à l'unité de pilotage 84, sont disposés dans le ciel gazeux du réservoir 70.

L'unité 84 est reliée à la soupape 80 pour sa commande.

L'unité 84 est propre à chauffer le réservoir 70 lorsque la puissance électrique mesurée par le capteur 90 augmente, et à refroidir le réservoir 70 lorsque la puissance électrique mesurée par le capteur 90 baisse. Ainsi, lorsque la puissance électrique fournie par le convertisseur augmente, la température de vaporisation du fluide de refroidissement à l'état liquide est augmentée, ce qui améliore les performances thermiques dans les évaporateurs 60A, 60B, 60C, 60D, et, lorsque la puissance électrique fournie par le convertisseur diminue, la température de vaporisation du fluide à l'état liquide est abaissée, ce qui diminue les performances thermiques des évaporateurs capillaires 60A, 60B, 60C, 60D.

L'unité de pilotage 84 est également apte, en cas de détection d'une température excessive par le capteur 92, à commander le réchauffage du réservoir 70 pour accroître les performances de dissipation thermique dans les évaporateurs 60A, 60B, 60C, 60D.

Enfin, l'unité 84 est apte à vérifier au cours du temps la pureté du fluide de refroidissement au sein du réservoir 70. A cet effet, elle est adaptée pour mesurer la température Tₛₐₜ et la pression Pₛₐₜ dans le réservoir depuis les capteurs de pression 94 et de température 96. Par ailleurs, elle est adaptée pour calculer à partir d'une formule résultant d'une modélisation, une température théorique Tₛₐₜₜₕ. L'unité 84 est adaptée pour comparer la température théorique Tₛₐₜₜₕ et la température Tₛₐₜ mesurée, et :
- si la température théorique Tₛₐₜₜₕ est différente de la température mesurée Tₛₐₜ, actionner la soupape 80 de façon à dégazer le réservoir 70, ce qui permet d'évacuer les incondensables présents dans le ciel gazeux du réservoir 70,
- si la température théorique Tₛₐₜₜₕ est égale à la température mesurée Tₛₐₜ, en déduire que le fluide de refroidissement est considéré comme pur dans la plage de précision demandée lors de la comparaison, et ne pas intervenir sur le réservoir 70.

Cela permet de conserver plus longtemps les bonnes performances du circuit de refroidissement 14.

L'unité 84 est également apte à réintroduire périodiquement du liquide de refroidissement dans le circuit 14 par l'orifice 82 pour compenser les pertes de fluide de refroidissement par dégazage.

L'unité 84 est programmée pour répéter les étapes précédemment décrites en boucle.

On comprend ainsi que la température de fonctionnement de la boucle 26, est contrôlée par le réservoir pressuriseur 70 diphasique. Ce réservoir 70 est contrôlé thermiquement de manière à assurer un contrôle de sa température de vaporisation, qui permet de contrôler les performances thermiques dans les évaporateurs 60A, 60B, 60C, 60D.

Dans ces conditions, la température de consigne, c'est-à-dire la température de jonction des organes de commutation 22, est contrôlée avec une bonne précision, et ce quelque soit la variation de puissance thermique devant être évacuée par le circuit de refroidissement 14.

Grâce à l'invention décrite ci-dessus, l'encombrement du circuit de refroidissement 14 et, par suite, du convertisseur 10, est réduit. En outre, du fait de l'absence de pompe mécanique à entretenir, la maintenance du convertisseur 10 est facilitée.

On notera que, plutôt que le transformateur 13, la boucle de refroidissement 26 peut être utilisée pour refroidir d'autres composants électromagnétiques du convertisseur de puissance 10. Aussi, dans des variantes de l'invention (non représentées), un bobinage ou un composant capacitif est substitué au transformateur 13.

## Revendications

1. Convertisseur de puissance électrique (10) pour un véhicule ferroviaire, comprenant :
- un premier composant électromagnétique (13) propre à participer à la conversion du courant électrique,
- un organe source de chaleur (22), distinct du premier composant électromagnétique (13), et
- un circuit de refroidissement (14), comprenant :
∘ un fluide caloporteur diphasique,
∘ une boucle (26) de circulation du fluide caloporteur, comprenant :
▪ un premier échangeur thermique (27), appliqué contre ledit premier composant électromagnétique,
▪ un deuxième échangeur thermique (28) propre à évacuer la chaleur du fluide caloporteur hors du circuit de refroidissement (14), et
▪ des moyens (29) de mise en communication fluidique du premier échangeur thermique (27) avec le deuxième échangeur thermique (28), et
∘ des moyens (59) de mise en circulation du fluide caloporteur dans la boucle de refroidissement (26),
**caractérisé en ce que** le circuit de refroidissement (14) est adapté pour refroidir l'organe source de chaleur (22), et **en ce que** les moyens de mise en circulation (59) comprennent au moins un évaporateur capillaire (60A, 60B, 60C, 60D), traversé par le fluide caloporteur et appliqué contre l'organe source de chaleur (22), le fluide caloporteur circulant dans la boucle de refroidissement (26) sous l'effet de la pression générée au niveau de l'interface liquide/vapeur dans le ou chaque évaporateur capillaire (60A, 60B, 60C, 60D).

2. Convertisseur de puissance électrique (10) selon la revendication 1, dans lequel le ou chaque évaporateur capillaire (60A, 60B, 60C, 60D) comprend une mèche capillaire (74) propre à assurer une vaporisation complète du fluide caloporteur, reçu à l'état liquide depuis une conduite (62A) de transport de fluide de refroidissement, et à renvoyer le fluide caloporteur en totalité à l'état gazeux par une conduite (62B) de transport de vapeur,

3. Convertisseur de puissance électrique (10) selon la revendication 2, dans lequel la vaporisation complète a lieu au niveau d'un ménisque établi dans la mèche (74) et séparant les phases liquide et vapeur du fluide caloporteur.

4. Convertisseur de puissance électrique (10) selon l'une quelconque des revendications précédentes, dans lequel le circuit de refroidissement (14) est dépourvu de pompe mécanique de mise en circulation du fluide caloporteur dans la boucle (26).

5. Convertisseur de puissance électrique (10) selon l'une quelconque des revendications précédentes, dans lequel l'organe source de chaleur (22) est un deuxième composant électromagnétique, propre à participer à la conversion du courant électrique et ayant une émission thermique supérieure à celle du premier composant électromagnétique (13), par exemple un composant électrique de puissance.

6. Convertisseur de puissance électrique (10) selon l'une quelconque des revendications précédentes, dans lequel la boucle (26) comprend le ou chaque évaporateur capillaire (60A, 60B, 60C, 60D), le premier échangeur thermique (27) et le ou chaque évaporateur capillaire (60A, 60B, 60C, 60D) étant raccordés fluidiquement en série l'un à l'autre au travers du deuxième échangeur thermique (28).

7. Convertisseur de puissance électrique (10) selon la revendication 6, dans lequel le deuxième échangeur thermique (28) est en aval du premier échangeur thermique (27) et en amont du ou de chaque évaporateur capillaire (60A, 60B, 60C, 60D).

8. Convertisseur de puissance électrique (10) selon la revendication 6 ou 7, dans lequel la boucle (26) comprend une branche (69A) d'amenée du fluide caloporteur depuis le premier échangeur de chaleur (27) jusqu'au ou à chaque évaporateur capillaire (60A, 60B, 60C, 60D), et une branche (69B), parallèle à la branche d'amenée (69A), de retour du fluide caloporteur depuis le ou chaque évaporateur capillaire (60A, 60B, 60C, 60D) jusqu'au premier échangeur de chaleur (27).

9. Convertisseur de puissance électrique (10) selon la revendication 8, dans lequel le deuxième échangeur thermique (28) est monté sur la branche d'amenée (69A), et la boucle (26) comprend un quatrième échangeur thermique (61), propre à évacuer la chaleur du fluide caloporteur hors du circuit de refroidissement (14) et monté sur la branche de retour (69B).

10. Convertisseur de puissance électrique (10) selon l'une quelconque des revendications précédentes, dans lequel la boucle (26) est une boucle à pompage capillaire.

11. Convertisseur de puissance électrique (10) selon l'une quelconque des revendications précédentes, dans lequel le circuit de refroidissement (14) comporte, en amont du ou de chaque évaporateur capillaire (60A, 60B, 60C, 60D), un réservoir (70) de pressurisation du fluide caloporteur à l'état liquide, le réservoir (70) étant placé à un niveau supérieur à celui du ou de chaque évaporateur capillaire (60A, 60B, 60C, 60D).

12. Convertisseur de puissance électrique (10) selon l'une quelconque des revendications précédentes, dans lequel le circuit de refroidissement (14) comprend des moyens (84) de contrôle des paramètres de pression et/ou de température du fluide caloporteur en amont du ou de chaque évaporateur capillaire (60A, 60B, 60C, 60D).

13. Convertisseur de puissance électrique (10) selon l'une quelconque des revendications précédentes, dans lequel le premier échangeur de chaleur (27) comprend une conduite (31) de circulation du fluide caloporteur, et un matériau diélectrique conducteur thermique (30), interposé entre le premier composant (13) et la conduite de circulation (31).

14. Convertisseur de puissance électrique (10) selon l'une quelconque des revendications précédentes, dans lequel le premier composant (13) est un composant magnétique, par exemple un transformateur ou une bobine d'induction, ou un composant capacitif, par exemple un condensateur ou un accumulateur.

15. Véhicule ferroviaire comportant une chaîne de traction comprenant un moteur électrique et un convertisseur de puissance électrique (10) selon l'une quelconque des revendications précédentes.

## Patentansprüche

1. Elektrischer Leistungswandler (10) für ein Schienenfahrzeug, aufweisend:
- ein erstes elektromagnetisches Bauelement (13), das geeignet ist, an der Umwandlung des elektrischen Stroms beteiligt zu sein,
- ein Wärmequellenmittel (22), das sich von dem ersten elektromagnetischen Bauelement (13) unterscheidet, und
- einen Kühlkreislauf (14), aufweisend:
∘ ein Zweiphasen-Wärmeübertragungsfluid,
∘ eine Schleife (26) zum Zirkulieren des Wärmeübertragungsfluids, aufweisend:
▪ einen ersten Wärmetauscher (27), der an dem ersten elektromagnetischen Bauelement anliegt,
▪ einen zweiten Wärmetauscher (28), der geeignet ist, die Wärme des Wärmeübertragungsfluids aus dem Kühlkreislauf (14) abzuleiten, und
▪ Mittel (29) zum In-FluidKommunikation-Bringen des ersten Wärmetauschers (27) mit dem zweiten Wärmetauscher (28), und
∘ Mittel (59) zum In-Umlauf-Bringen des Wärmeübertragungsfluids in der Kühlschleife (26),
**dadurch gekennzeichnet, dass** der Kühlkreislauf (14) angepasst ist, um das Wärmequellenmittel (22) abzukühlen, und dass die Mittel zum In-Umlauf-Bringen (59) mindestens einen Kapillarverdampfer (60A, 60B, 60C, 60D) aufweisen, der von dem Wärmeübertragungsfluid durchquert wird und an dem Wärmequellenmittel (22) anliegt, wobei das Wärmeübertragungsfluid unter der Einwirkung des Drucks, der an der Flüssigkeit-/Dampf-Grenzfläche in dem oder jedem Kapillarverdampfer (60A, 60B, 60C, 60D) erzeugt wird, in der Kühlschleife (26) zirkuliert.

2. Elektrischer Leistungswandler (10) gemäß Anspruch 1, wobei der oder jeder Kapillarverdampfer (60A, 60B, 60C, 60D) einen Kapillardocht (74) aufweist, der geeignet ist, eine vollständige Verdampfung des Wärmeübertragungsfluids sicherzustellen, das im flüssigen Zustand aus einer Leitung (62A) zum Transportieren von Kühlflüssigkeit empfangen wird, und das Wärmeübertragungsfluid in seiner Gesamtheit im gasförmigen Zustand durch eine Leitung (62B) zum Transportieren von Dampf zurückzuschicken.

3. Elektrischer Leistungswandler (10) gemäß Anspruch 2, wobei die vollständige Verdampfung an einem in dem Docht (74) ausgebildeten Meniskus stattfindet, der sich in dem Docht (74) ausbildet und die Flüssigphase und die Dampfphase des Wärmeübertragungsfluids voneinander trennt.

4. Elektrischer Leistungswandler (10) gemäß irgendeinem der vorhergehenden Ansprüche, wobei der Kühlkreislauf (14) ohne mechanische Pumpe zum In-Umlauf-Bringen des Wärmeübertragungsfluids in der Schleife (26) vorgesehen ist.

5. Elektrischer Leistungswandler (10) gemäß irgendeinem der vorhergehenden Ansprüche, wobei das Wärmequellenmittel (22) ein zweites elektromagnetisches Bauelement, das geeignet ist, sich an der Umwandlung des elektrischen Stroms zu beteiligen und eine größere thermische Emission als diejenige des ersten elektromagnetischen Bauelements (13) hat, zum Beispiel ein elektrisches Leistungsbauelement ist.

6. Elektrischer Leistungswandler (10) gemäß irgendeinem der vorhergehenden Ansprüche, wobei die Schleife (26) den oder jeden Kapillarverdampfer (60A, 60B, 60C, 60D) aufweist, wobei der erste Wärmetauscher (27) und der oder jeder Kapillarverdampfer (60A, 60B, 60C, 60D) in Fluidverbindung nacheinander durch den zweiten Wärmetauscher (28) hindurch in Reihe geschaltet sind.

7. Elektrischer Leistungswandler (10) gemäß Anspruch 6, wobei der zweite Wärmetauscher (28) stromabwärts von dem ersten Wärmetauscher (27) und stromaufwärts von dem oder jedem Kapillarverdampfer (60A, 60B, 60C, 60D) ist.

8. Elektrischer Leistungswandler (10) gemäß Anspruch 6 oder 7, wobei die Schleife (26) einen Zweig (69A) zum Zuleiten des Wärmeübertragungsfluids von dem ersten Wärmetauscher (27) bis zu dem oder jedem Kapillarverdampfer (60A, 60B, 60C, 60D) und einen Zweig (69B) parallel zum Zuleitungszweig (69A) zum Rückleiten des Wärmeübertragungsfluids von dem oder jedem Kapillarverdampfer (60A, 60B, 60C, 60D) bis zum ersten Wärmetauscher (27) aufweist.

9. Elektrischer Leistungswandler (10) gemäß Anspruch 8, wobei der zweite Wärmetauscher (28) an dem Zuleitungszweig (69A) montiert ist und die Schleife (26) einen vierten Wärmetauscher (61) aufweist, der geeignet ist, die Wärme des Wärmeübertragungsfluids aus dem Kühlkreislauf (14) herauszuleiten, und an dem Rückleitungszweig (69B) montiert ist.

10. Elektrischer Leistungswandler (10) gemäß irgendeinem der vorhergehenden Ansprüche, wobei die Schleife (26) eine Kapillarpumpenschleife ist.

11. Elektrischer Leistungswandler (10) gemäß irgendeinem der vorhergehenden Ansprüche, wobei der Kühlkreislauf (14) stromaufwärts von dem oder jedem Kapillarverdampfer (60A, 60B, 60C, 60D) einen Behälter (70) für eine Druckbeaufschlagung des Wärmeübertragungsfluids im flüssigen Zustand aufweist, wobei der Behälter (70) auf einer höheren Ebene als diejenige des oder jedes Kapillarverdampfers (60A, 60B, 60C, 60D) platziert ist.

12. Elektrischer Leistungswandler (10) gemäß irgendeinem der vorhergehenden Ansprüche, wobei der Kühlkreislauf (14) Mittel (84) zum Steuern der Druck- und/oder Temperatur-Parameter des Wärmeübertragungsfluids stromaufwärts von dem oder jedem Kapillarverdampfer (60A, 60B, 60C, 60D) aufweist.

13. Elektrischer Leistungswandler (10) gemäß irgendeinem der vorhergehenden Ansprüche, wobei der erste Wärmetauscher (27) eine Leitung (31) zum Zirkulieren des Wärmeübertragungsfluids und ein thermisch leitendes dielektrisches Material (30) aufweist, das zwischen dem ersten Bauelement (13) und der Zirkulationsleitung (31) angeordnet ist.

14. Elektrischer Leistungswandler (10) gemäß irgendeinem der vorhergehenden Ansprüche, wobei das erste Bauelement (13) ein magnetisches Bauelement, zum Beispiel ein Transformator oder eine Induktionsschleife, oder ein kapazitives Bauelement, zum Beispiel ein Kondensator oder ein Akkumulator ist.

15. Schienenfahrzeug, das einen Antriebsstrang aufweist, der einen Elektromotor und einen elektrischen Leistungswandler (10) gemäß irgendeinem der vorhergehenden Ansprüche aufweist.

## Claims

1. Electric power converter (10) for a rail vehicle, comprising:
- a first electromagnetic component (13) capable of participating in the conversion of the electric current,
- a heat source element (22), separate from the first electromagnetic component (13), and
- a cooling circuit (14) comprising:
∘ a two-phase heat transfer fluid,
∘ a loop (26) for circulation of the heat transfer fluid, comprising:
▪ a first heat exchanger (27) applied to said first electromagnetic component,
▪ a second heat exchanger (28) capable of evacuating the heat from the heat transfer fluid outside the cooling circuit (14), and
▪ means (29) for placing the first heat exchanger (27) in fluidic communication with the second heat exchanger (28), and
∘ means (59) for circulating the heat transfer fluid in the cooling loop (26),
**characterised in that** the cooling circuit (14) is adapted to cool the heat source element (22), and **in that** the circulating means (59) comprise at least one capillary evaporator (60A, 60B, 60C, 60D) through which the heat transfer fluid passes and which is applied to the heat source element (22), the heat transfer fluid circulating in the cooling loop (26) under the effect of the pressure generated at the liquid/vapour interface in the or each capillary evaporator (60A, 60B, 60C, 60D).

2. Electric power converter (10) according to claim 1, wherein the or each capillary evaporator (60A, 60B, 60C, 60D) comprises a capillary wick (74) capable of effecting complete vaporisation of the heat transfer fluid received in the liquid state from a cooling fluid transport pipe (62A), and of sending the heat transfer fluid wholly in the gaseous state through a vapour transport pipe (62B).

3. Electric power converter (10) according to claim 2, wherein complete vaporisation takes place at a meniscus established in the wick (74) and separating the liquid and vapour phases of the heat transfer fluid.

4. Electric power converter (10) according to any one of the preceding claims, wherein the cooling circuit (14) does not have a mechanical pump for circulating the heat transfer fluid in the loop (26).

5. Electric power converter (10) according to any one of the preceding claims, wherein the heat source element (22) is a second electromagnetic component which is capable of participating in the conversion of the electric current and the thermal emission of which is greater than that of the first electromagnetic component, for example an electric power component.

6. Electric power converter (10) according to any one of the preceding claims, wherein the loop (26) comprises the or each capillary evaporator (60A, 60B, 60C, 60D), the first heat exchanger (27) and the or each capillary evaporator (60A, 60B, 60C, 60D) being connected fluidically in series to one another through the second heat exchanger (28).

7. Electric power converter (10) according to claim 6, wherein the second heat exchanger (28) is downstream of the first heat exchanger (27) and upstream of the or each capillary evaporator (60A, 60B, 60C, 60D).

8. Electric power converter (10) according to claim 6 or 7, wherein the loop (26) comprises a branch (69A) for feeding the heat transfer fluid from the first heat exchanger (27) to the or each capillary evaporator (60A, 60B, 60C, 60D), and a branch (69B), parallel to the feed branch (69A), for returning the heat transfer fluid from the or each capillary evaporator (60A, 60B, 60C, 60D) to the first heat exchanger (27).

9. Electric power converter (10) according to claim 8, wherein the second heat exchanger (28) is mounted on the feed branch (69A), and the loop (26) comprises a fourth heat exchanger (61) which is capable of evacuating the heat from the heat transfer fluid outside the cooling circuit (14) and is mounted on the return branch (69B).

10. Electric power converter (10) according to any one of the preceding claims, wherein the loop (26) is a capillary pumped loop.

11. Electric power converter (10) according to any one of the preceding claims, wherein the cooling circuit (14) comprises, upstream of the or each capillary evaporator (60A, 60B, 60C, 60D), a reservoir (70) for pressurisation of the heat transfer fluid in the liquid state, the reservoir (70) being located at a level higher than that of the or each capillary evaporator (60A, 60B, 60C, 60D).

12. Electric power converter (10) according to any one of the preceding claims, wherein the cooling circuit (14) comprises means (84) for controlling the pressure parameters and/or temperature parameters of the heat transfer fluid upstream of the or each capillary evaporator (60A, 60B, 60C, 60D).

13. Electric power converter (10) according to any one of the preceding claims, wherein the first heat exchanger (27) comprises a pipe (31) for circulating the heat transfer fluid, and a thermally conductive dielectric material (30) interposed between the first component (13) and the circulation pipe (31).

14. Electric power converter (10) according to any one of the preceding claims, wherein the first component (13) is a magnetic component, for example a transformer or an induction coil, or a capacitive component, for example a capacitor or an accumulator.

15. Rail vehicle having a traction chain comprising an electric motor and an electric power converter (10) according to any one of the preceding claims.
